Europäisches Patentamt

European Patent Office

Office européen des brevets

(19)

(11) Veröffentlichungsnummer: **0 002 531**
**B1**

(12) **EUROPÄISCHE PATENTSCHRIFT**

(21) Anmeldenummer: **78101698.5**

(22) Anmeldetag: **15.12.78**

(51) Int. Cl.³: **G 03 D  5/06,  G 03 F  7/02**

(54) Rakeleinrichtung in Druckplattenentwicklungsmaschinen

(30) Priorität: **21.12.77 DE 2756932**

(43) Veröffentlichungstag der Anmeldung:
**27.06.79 Patentblatt 79/13**

(45) Bekanntmachung des Hinweises auf die Patenterteilung:
**17.09.80 Patentblatt 80/19**

(84) Benannte Vertragsstaaten:
**BE DE FR GB NL SE**

(56) Entgegenhaltungen:
**DE - A - 1 710 518**
**GB - A - 360 175**
**NL - A. 72 05180**
**US - A - 1 612 250**

(73) Patentinhaber: **HOECHST AKTIENGESELLSCHAFT KALLE, Patentabteilung Postfach 3540 D - 6200 Wiesbaden 1 (DE)**

(72) Erfinder: **Heist, Hans Frankenwaldstrasse 7 D - 6200 WI-Delkenheim (DE) Töpfer, Dieter Mühlweg 5 D - 6209 Heidenrod 3 (DE)**

Rakeleinrichtung in Druckplattenentwicklungsmaschinen

Die Erfindung betrifft eine Rakeleinrichtung in Druckplattenentwicklungsmaschinen mit mindestens einem aus elastischem Material bestehenden Abstreifrakel, der in einer Führungsleiste lösbar befestigt ist sowie mit Haltemitteln, mit denen der Abstreifrakel an zwei Seitenschildern der Druckplattenentwicklungsmaschine anbringbar ist.

Bei einer derartigen, zum Stand der Technik gehörenden Rakeleinrichtung wird als Abstreifrakel ein zugeschnittener schmaler Gummistreifen verwendet. Die Führungsleiste selbst besteht aus einem aus Blechstreifen gekantetem U-Profil. In dieses U-Profil wird der Abstreifrakel eingelegt, wonach die Schenkel des U-Profils zusammengedrückt werden. Zusätzlich wird der Abstreifrakel an zueinander beabstandeten Stellen mit dem U-Profil verschraubt. Da diese Führungsleiste selbst mit dem Abstreifrakel nicht formstabil ist, wird sie mit einem Rakelträger einer Trägerleiste verschraubt. Dieser Rakelträger ist wiederum mit Befestigungselementen in der Maschine zu verschrauben.

Bei dieser bekannten Rakeleinrichtung ist nachteilig, daß der Abstreifrakel nur verhältnismäßig umständlich und mit Werkzeug ausgewechselt werden kann. Hierzu ist zunächst die Trägerleiste auszubauen, anschließend ist das U-Profil mit dem Gummistreifen vollständig abzuschrauben, danach sind die Befestigungsschrauben des Gummistreifens mit der Führungsleiste zu lösen und schließlich kann der Gummistreifen ausgetauscht werden. Diese Arbeit und das anschließende Montieren kann oft nicht durch den Benutzer der Maschine, sondern nur durch geschultes Kundendienstpersonal vorgenommen werden. Besonders schwierig gestaltet sich der Austausch des den Abstreifrakel bildenden schmalen Gummistreifens, da sich dieser beim Einklemmen in die Führungsleiste infolge der Weichheit des Rakelgummis insbesondere an den Stellen der Schraubbefestigung verformt, so daß die Abstreifkante des Abstreifrakels nicht mehr ohne weiteres gerade verläuft. Deswegen muß die Abstreifkante des Rakels nach dem Einklemmen des Gummistreifens in die Führungsleiste häufig nachgeschnitten werden.

Zum Stand der Technik (US—PS 3 983 758) gehört ferner eine Einrichtung zur Befestigung eines Schwammes in einer automatischen Entwicklungsmaschine für Offsetdruckplatten. Diese Einrichtung unterscheidet sich insofern gattungsmäßig von der vorliegenden Rakeleinrichtung, als der Schwamm eine andere Funktion als der Abstreifrakel ausübt. Hierzu ist der Schwamm quer zur Transportrichtung der Druckplatte auf dieser hin und her bewegbar. Auf der Eingabeseite der Druckplatte in die Druckplattenentwicklungsmaschine dient der hin und her bewegbare Schwamm dazu, Entwicklerlösung auf der Druckplatte zu verreiben. Auf der Ausgangsseite ist der Schwamm dazu vorgesehen, Waschwasser auf der Druckplatte zu verreiben. Zu der erforderlichen Hin- und Herbewegung des Schwammes ist ein Schwammstab, der einen U-förmig nach unten geöffneten Kanal trägt, in den der Schwamm eingelassen ist, aus einem Seitenschild der Druckplattenentwicklungsmaschine herausragend ausgebildet, so daß das herausragende Ende mit einem Kurbelantrieb gekuppelt werden kann. An der Austrittsstelle des Schwammstabs ist das Seitenschild mit je zwei Gleitsteinen verstärkt, die eine Öffnung umgeben, in die der Schwammstab von oben eingelegt werden kann. Die Gleitsteine führen den Schwammstab in Richtung der Hin- und Herbewegung quer zur Druckplattentransportrichtung. Die bekannte Einrichtung weist ferner an jedem Ende, an dem der Schwammstab aus einem Seitenschild herausragt, einstellbare Andruckmittel auf, um einen zusätzlichen Reibedruck an jedem Schwamm einzustellen. Dies geschieht durch einen Z-förmigen Arm, an dessen einem Ende eine Rolle drehbar gelagert ist, die auf der Oberseite des Schwammstabs abrollen kann, während das entgegengesetzte Ende des Z-förmigen Andruckarms einstellbar in mit dem Seitenschild in Verbindung stehenden Blöcken befestigt ist. Je nach dem, wie hoch dieses Ende in dem Block befestigt ist, wird durch die Rolle an dem entgegengesetzten Armende ein unterschiedlicher zusätzlicher Druck zu dem Gewicht des Schwammstabs und der mit ihm verbundenen Teile auf die Druckplatte ausgeübt.

Die Konstruktion dieser Schwammeinrichtung läßt sich jedoch nicht ohne weiteres auf eine Rakeleinrichtung übertragen, da der Abstreifrakel in der Druckplattenentwicklungsmaschine feststehend angeordnet sein soll, und da der Anpressdruck des Abstreifrakels auf die Druckplatte anders zu bemessen ist als der Reibedruck des Schwammes.

Der vorliegenden Erfindung liegt ausgehend von den Nachteilen der bekannten Rakeleinrichtung die Aufgabe zugrunde, eine Rakeleinrichtung zu schaffen, deren Führungsleiste mit dem Abstreifrakel und deren Abstreifrakel selbst schnell und ohne Werkzeug aus der Druckplattenentwicklungsmaschine ausgebaut und gereinigt bzw. im Bedarfsfall ausgetauscht werden kann.

Diese Aufgabe wird erfindungsgemäß durch die in dem kennzeichnenden Teil des Anspruchs 1 angegebenen Merkmale gelöst.

Bei dieser Ausbildung kann die Führungsleiste zusammen mit der anhängenden Trägerleiste und dem Rakelgummi ohne Lösen irgendeiner Verbindung einfach nach oben aus den Seitenschildern der Druckplattenentwicklungsmaschine herausgezogen werden, wenn die Rakeleinrichtung gereinigt oder ausgebessert werden soll. In gleich einfacher Weise kann die Führungsleiste mit der Trägerleiste und dem in der Führungsleiste angebrachten Abstreifrakel wieder in die Maschine eingesetzt werden. Dabei stützen sich die an der Oberseite der Trägerleiste beidseitig angebrachten Stützmittel auf den U-Profilstücken an beiden Seitenschildern ab, so daß nicht das gesamte Gewicht der aus Führungsleiste, Trägerleiste und Abstreifrakel gebildeten Einheit an der Lippe des Abstreifrakels auf der Druckplatte lastet. Die aus Führungsleiste, Trägerleiste und Abstreifrakel gebildete Einheit ist in der Druckplattenentwicklungsmaschine stationär angeordnet. Hierzu wird die Trägerleiste beidseitig in den U-Profilstücken sowohl gegen eine Verschiebung in Transportrichtung der Druckplatte und hierzu entgegengesetzt als auch gegen eine Verschiebung quer zur Druckplatte in wenig aufwendiger, aber sicherer Weise gehalten. Der Herstellaufwand dieser Rakeleinrichtung kann ferner deswegen niedrig sein, da die Führungsleiste und die Trägerleiste aus Halbzeugprofilen geformt werden können.

Die Rakeleinrichtung ist ferner zweckmäßig mit dem Merkmal ausgebildet, daß die Stützmittel an der Trägerleiste einstellbar angebracht sind, so daß die Aufteilung des Gewichts, mit dem die Trägerleiste samt Führungsleiste und Abstreifrakel einerseits auf die Berührungslinie des Abstreifrakels auf der Druckplatte drückt und andererseits auf beide U-Profilstücke drückt, einregulierbar ist.

Hier wird also in einer für das Abrakeln vorteilhaften Weise von dem Gesamtgewicht der Einheit Führungsleiste, Trägerleiste und Abstreifrakel eine Komponente abgeteilt, die von den U-Profilstücken getragen wird, so daß nur die restliche Gewichtskomponente mit der Lippe des Abstreifrakels auf die Druckplatte drückt. Dieser Druck kann somit in einfacher Weise derart eingestellt werden, daß die Flüssigkeit von der Oberfläche der Druckplatte sauber entfernt wird, daß jedoch andererseits die mechanisch empfindliche Druckplattenoberfläche nicht beschädigt wird.

Die einstellbaren Stützmittel lassen sich in einer Weiterbildung der Rakeleinrichtung bevorzugt mit dem Merkmal verw-irklichen, daß als einstellbares Stützmittel an jedem Ende der Trägerleiste eine erste Rändelmutter auf einen in die Trägerleiste eingelassenen Gewindebolzen gedreht ist, die durch eine zweite Rändelmutter konterbar ist.

Bei dieser Ausbildung liegt die Unterseite der Rändelmutter in bevorzugter Weise sowohl auf beiden Schenkeln als auf dem Steg des U-Profilstücks. Je nach dem, wie weit diese Rändelmutter an dem Gewindebolzen herabgedreht ist, wird die obere Seite des Abstreifrakels, nämlich die Kopfleiste des Abstreifrakels, mehr oder weniger gegenüber der Druckplatte angehoben, so daß die Lippe des Abstreifrakels in einstellbarer Stärke auf die Druckplatte drückt.

Die geeignete Stellung der ersten Rändelmutter und der damit erzielte Anspressdruck wird durch Konterung der zweiten Rändelmutter in einfacher Weise gesichert.

In einer bevorzugten Ausführungsform der Rakeleinrichtung ist die Führungsleiste mit der Trägerleiste einstückig ausgebildet.

Die aus einem einzigen Strangpressteil gebildete Einheit der Führungsleiste und der Trägerleiste zeichnet sich gegenüber der zweistückigen Ausbildung der Führungsleiste und der Trägerleiste, die miteinander zu verbinden sind, durch besonders geringen Montageaufwand aus.

In einer vorteilhaften Variante der Rakeleinrichtung hat diese die Merkmale, daß die Fürungsleiste formstabil mit U-förmigem, nach unten offenem Querschnitt ausgebildet ist, und daß in die Führungsleiste ein Rakelgummi von der Seite her einschiebbar ist, welches eine im Querschnitt annähernd rechteckförmige Kopfleiste mit längsseits aus zwei parallelen Seitenflächen aufgeformten Widerhaken aufweist.

Dieses Rakelgummi kann, da sich die Widerhaken beim seitlichen Einziehen in die U-förmige Führungsleiste zurückbiegen, mit verhältnismäßig geringem Kraftaufwand eingezogen werden, andererseits wird dieser Rakelgummi mit den Widerhaken sicher in der Führungsleiste im U-förmigen Querschnitt gehalten. Eine Verformung des U-förmigen Querschnitts der Führungsleiste zur Befestigung des Rakelgummis ist also nicht erforderlich.

Eine zweite Variante der Rakeleinrichtung zeichnet sich durch die Merkmale aus, daß die Führungsleiste formstabil mit annähernd kastenförmigen Profil ausgebildet ist, das nach unten einen Längsschlitz aufweist, daß der Rakelgummi mit einer im Querschnitt annähernd ringförmigen Kopfleiste ausgebildet ist, die nach unten in eine Lippe ausläuft, und daß die Lippe des Rakelgummis durch den Längsschlitz des kastenförmigen Profils nach außen herausragt.

Diese Variante der Rakeleinrichtung weist die gleichen Vorteile wie die voranstehend beschriebene Rakeleinrichtung auf. Sie hat jedoch darüber hinaus noch die Vorteile, daß der Rakelgummi besonders leicht seitlich in die Führungsleiste eingezogen werden kann, wobei sich die Kopfleiste zusammendrückt, und daß andererseits der Rakelgummi besonders zuverlässig gegen ein Herausziehen nach unten bzw. in Transportrichtung der Druckplatte gesichert ist, da die Kopfleiste durch die Profilteile neben dem Längsschlitz sicher gehalten wird.

Der Rakelgummi ist in beiden Varianten zweckmäßig als Strangziehteil aus Silikongummi ausgebildet.

Die Erfindung wird im folgenden anhand einer Zeichnung mit vier Figuren erläutert.

Es zeigt:

Fig. 1 einen Querschnitt durch die Rakeleinrichtung in Richtung auf eine Seitenplatine einer Druckplattenentwicklungsmaschine,

Fig. 2 eine Vorderansicht auf einen Abschnitt der Rakeleinrichtung im Bereich einer Seitenplatine,

Fig. 3 eine erste Variante der Führungsleiste und des Rakelgummis in einem vergrößerten Ausschnitt im Querschnitt und

Fig. 4 eine zweite Variante der Führungsleiste und des Rakelgummis in einem unteren, vergrößerten Ausschnitt im Querschnitt.

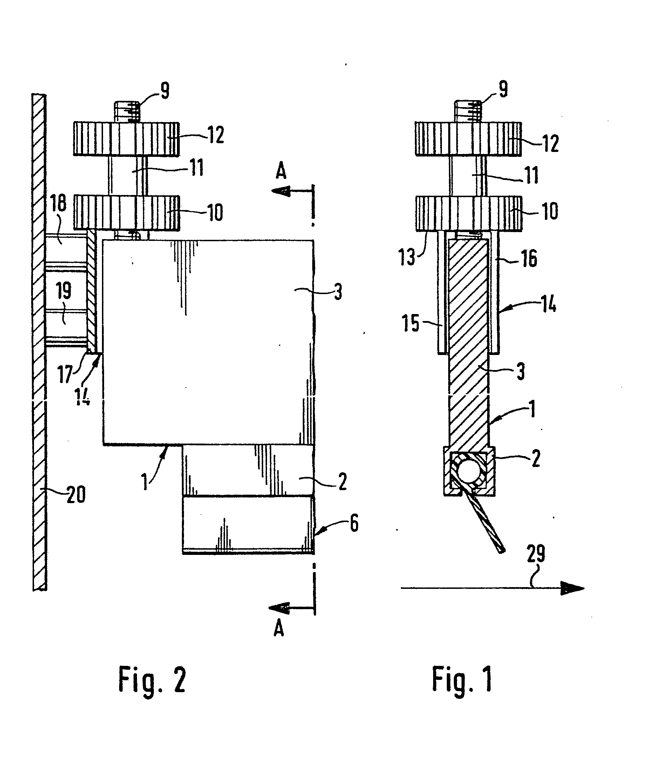

In Fig. 2 ist ein Ausschnitt aus einer Einheit 1 dargestellt, die aus einer längsgestreckten Führungsleiste und Trägerleiste besteht. Fig. 1 stellt dabei einen Schnitt A—A in Fig. 2 dar.

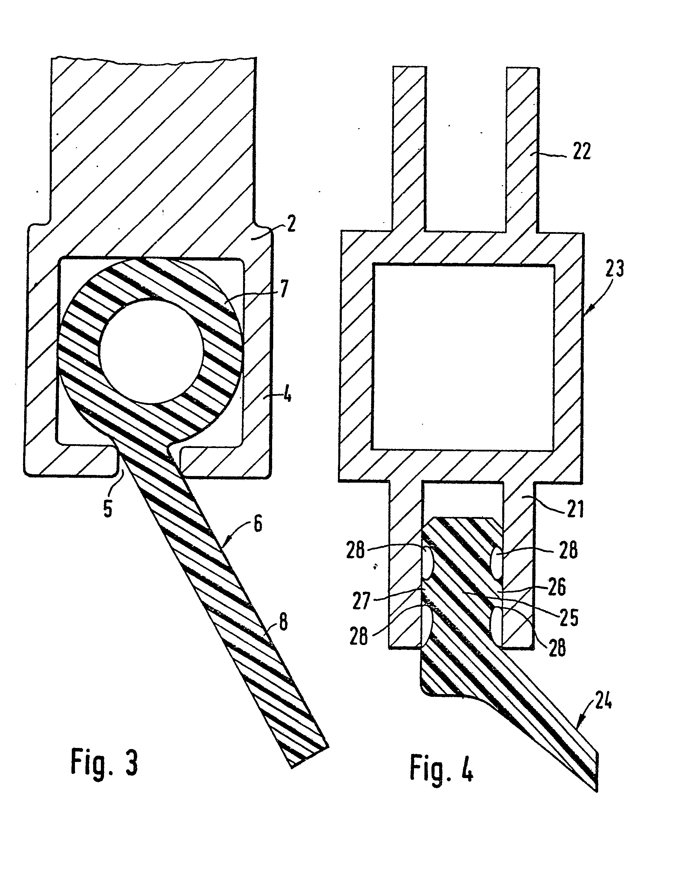

Von der Einheit 1 bildet der untere Abschnitt 2 die Führungsleiste und der sich daran anschließende obere Abschnitt 3 die Trägerleiste. Diese Einheit ist aus einem Strangpressprofil aus Aluminium gebildet. Der untere der Führungsleiste 2 entsprechende Abschnitt ist in Fig. 3 dargestellt. Dieser der Führungsleiste 2 entsprechende Abschnitt ist mit einem kastenförmigen Profil 4 ausgebildet, das durch einen unteren Längsschlitz 5 unterbrochen ist.

In das kastenförmige Profil ist ein Rakelgummi 6 eingeschoben, der eine im Querschnitt annähernd ringförmige Kopfleiste 7 aufweist. Nach unten läuft der Rakelgummi in eine Lippe 8 aus.

Wie aus den Figuren 1 und 2 hervorgeht, ist in den oberen Abschnitt der Einheit 1, der der Trägerleiste entspricht, auf der Oberseite an einem Ende ein Gewindebolzen 9 eingelassen. Diesem Gewindebolzen 9 entspricht an dem entgegengesetzten Ende der Einheit 1, die in der Zeichnung nicht dargestellt ist, ein zweiter Gewindebolzen, wie das gesamte, in der Zeichnung nicht dargestellte rechte Ende der Einheit in gleicher Weise wie das gezeigte linke Ende ausgebildet ist.

Auf dem Gewindebolzen ist eine untere Rändelmutter 10 aufgedreht, die durch ein Abstandsstück 11 von einer oberen Rändelmutter 12, die zur Konterung dient, getrennt ist.

Wie sich aus den Figuren 1 und 2 gemeinsam ergibt, liegt eine Unterseite 13 auf einem U-Profilstück 14 auf. Von dem U-Profilstück 14 sind in Fig. 1 zwei parallele Schenkel 15, 16 erkennbar, die durch einen in Fig. 2 dargestellten Steg 17 getrennt sind. Der Steg ist über Bolzen 18, 19 an einem Seitenschild 20 angebracht.

Die Rakeleinrichtung wird derart hergestellt, daß zunächst bei aus der Druckplattenentwicklungsmaschine gelöster Einheit 1 der Rakelgummi 6 in das kastenförmige Profilteil senkrecht zur Zeichnungsebene eingeschoben wird. Daran anschließend wird die gesamte Einheit 1 von oben in beide U-Profilstücke eingesetzt, wobei die Lippe 8 des Rakelgummis auf der Druckplatte bzw. auf dem Boden der Druckplattenentwicklungsmaschine zur Anlage gelangt. Der Anpressdruck der Lippe 8 wird durch die Höheneinstellung der Einheit 1 mittels der unteren Rändelmutter 10 variiert. Wenn die richtige Einstellung gefunden ist, wird die obere Rändelmutter 12 zu der unteren Rändelmutter hin fest aufgedreht, so daß die gefundene Höhenlage fixiert ist.

In der in Fig. 4 dargestellten zweiten Variante der Rakeleinrichtung ist die Führungsleiste 21, die ebenfalls mit der Trägerleiste 22 eine einstückige Einheit 23 bildet, nach unten U-förmig geöffnet ausgeformt. In die Führungsleiste 21 ist ein Rakelgummi 24 von der Seite her, d.h. senkrecht zur Zeichnungsebene einschiebbar. Der Rakelgummi hat eine annähernd rechteckförmige Kopfleiste 25. Aus den parallelen Längsseiten 26 und 27 der Kopfleiste sind Widerhaken 28 ausgebildet, die dafür sorgen, daß der Rakelgummi sicher in dem U-förmigen Profil gehalten wird.

## Patentansprüche

1. Rakeleinrichtung in einer Druckplattenentwicklungsmaschine, mit mindestens einem aus elastischem Material bestehenden Abstreifrakel (6; 24), der in einer Führungsleiste (2; 21) lösbar befestigt ist, sowie mit Haltemitteln, mit denen der Abstreifrakel an zwei Seitenschildern (20) der Druckplattenentwicklungsmaschine anbringbar ist, dadurch gekennzeichnet, daß die Führungsleiste (2; 21) mit einer Trägerleiste (3; 22) in Verbindung steht, deren Enden in je ein nach oben offenes U-Profilstück (14) mit je zwei durch einen Steg (17) beabstandeten Schenkeln (15, 16) von oben einführbar sind, daß jedes U-Profilstück mit seinem Steg (17) an je einem Seitenschild (20) derart befestigt ist, daß seine beiden Schenkel (15, 16) quer zur Druckplattentransportrichtung (29) zum Innern der Druckplattenentwicklungsmaschine gerichtet sind, und daß an der Oberseite der Trägerleiste (3; 22) beidseitig Stützmittel (9 bis 12) angebracht sind, mit denen sich die Trägerleiste (3; 22) samt der mit ihr in Verbindung stehenden Führungsleiste (2; 21) und dem Abstreifrakel (Rakelgummi 6; 24) auf die je einem U-Profilstück (14) abstützt.

2. Rakeleinrichtung nach Anspruch 1, dadurch gekennzeichnet, daß die Stützmittel (9 bis 12) an der Trägerleiste (3; 22) einstellbar angebracht sind, so daß die Aufteilung des Gewichts, mit dem die Trägerleiste (3; 22) samt Führungsleiste (2; 21) und Abstreifrakel (Rakelgummi 6; 24) einerseits auf die Berührungslinie des Abstreifrakels auf der Druckplatte drückt, und andererseits auf beide U-Profilstücke drückt, einregulierbar ist.

3. Rakeleinrichtung nach Anspruch 2, dadurch gekennzeichnet, daß als einstellbares Stützmittel (9 bis 12) an jedem Ende der Trägerleiste (3; 22) eine erste Rändelmutter (10) auf einen in die Trägerleiste eingelassenen Gewindebolzen (9) gedreht ist, die durch eine zweite Rändelmutter (12) konterbar ist.

4. Rakeleinrichtung nach einem der voranstehenden Ansprüche, dadurch gekennzeichnet, daß die Führungsleiste (2; 21) zusammen mit der Trägerleiste (3; 22) einstückig ausgebildet ist.

5. Rakeleinrichtung nach einem der voranstehenden Ansprüche, dadurch gekennzeichnet, daß die Führungsleiste (21) formstabil mit U-förmigem, nach unten offenem Querschnitt ausgebildet ist, und daß in die Führungsleiste der Rakelgummi (24) von der Seite her einziehbar ist, welcher eine im Querschnitt annähernd rechteckförmige Kopfleiste (25) mit aus zwei parallelen Seitenflächen (26, 27) längsseitig ausgeformten Widerhaken (28) aufweist.

6. Rakeleinrichtung nach einem der Ansprüche 1 bis 4, dadurch gekennzeichnet, daß die Führungsleiste (2) formstabil mit annähernd kastenförmigen Profil (4) ausgebildet ist, das nach unten einen Längsschlitz (5) aufweist, daß der Rakelgummi (6) mit einer im Querschnitt annähernd ringförmigen Kopfleiste (7) ausgebildet ist, die nach unten in eine Lippe (8) ausläuft, und daß die Lippe des Rakelgummis durch den Längsschlitz (5) des kastenförmigen Profils nach außen herausragt.

7. Rakeleinrichtung nach einem der vorangehenden Ansprüche, dadurch gekennzeichnet, daß der Rakelgummi (6; 24) als Strangziehteil aus Silikongummi ausgebildet ist.

**Claims**

1. A doctor blade device in an automatic processor for printing plates, comprising at least one doctor blade (6; 24) made of a flexible material and detachably mounted in a guide bar (2; 21), further comprising holding means for attaching the doctor blade to two side plates (20) of the printing plate processor, characterised in that the guide bar (2; 21) is connected with a carrier bar (3; 22) the ends of which may be inserted from above into a channel section (14) each, arranged with its opening pointing upwardly and having two arms (15 and 16) spaced by a web (17); in that each channel section is fastened by its web (17) to a side plate (20) each, in such a manner that its two arms (15 and 16) extend transversely to the transport direction (29) of the printing plate in the direction of the interior of the printing plate processor; and in that the upper surface of the carrier bar (3; 22) is provided with support means (9 to 12) at both ends, by which the carrier bar (3; 22) together with the connected guide bar (2; 21) and the doctor blade (doctor rubber 6; 24) rest upon a channel section (14) each.

2. A doctor blade device according to Claim 1, characterised in that the support means (9 to 12) are adjustably mounted on the carrier bar (3; 22) so that it is possible to regulate the distribution of the weight exerted by the carrier bar (3; 22) together with the guide bar (2; 21) and the doctor blade (doctor rubber 6; 24) on the one hand, upon the line of contact of the doctor blade on the printing plate and, on the other hand, upon the two channel sections.

3. A doctor blade device according to Claim 2, characterised in that the adjustable support means (9 to 12) include a first knurled nut (10) at each end of the carrier bar (3; 22), which is screwed on a threaded bolt (9) inserted in the carrier bar and which may be locked by a second knurled nut (12).

4. A doctor blade device according to any one of the preceding Claims, characterised in that the guide bar (2; 21) together with the carrier bar (3; 22) are made in one piece.

5. A doctor blade device according to any one of the preceding Claims, characterised in that the guide bar (21) is inherently stable and has a U-shaped cross-section which opens downwardly and in that the doctor rubber (24) may be laterally inserted into the guide bar and has a head strip (25) of an approximately rectangular cross-section with barbs (28) being formed lengthwise on two parallel lateral surfaces (26 and 27).

6. A doctor blade device according to any one of Claims 1 to 4, characterised in that the guide bar (2) is inherently stable and has an approximately box-shaped section (4) with longitudinal slot (5) at the bottom; in that the doctor rubber (6) has a head strip (7) of an approximately annular cross-section from which a lip (8) of the doctor blade extends downwardly; and in that the lip of the doctor rubber projects from the longitudinal slot (5) in the box-shaped section.

7. A doctor blade device according to any one of the preceding Claims, characterised in that the doctor rubber (6; 24) is an extruded piece made of silicone rubber.

**Revendications**

1. Dispositif de râclage pour appareils à développer les plaques d'impression, comportant au moins un râcloir, fixé d'une manière amovible dans une barre de guidage, ainsi que des éléments de fixation qui assurent la fixation du râcloir sur deux plaques latérales de cet appareil à dévellopper les plaques d'impression, ce dispositif de râclage étant caractérisé en ce que la barre de guidage (2, 21) est reliée à une barre porteuse (3, 22) dont l'extrémité est introduite de haut en bas dans un élément profilé en U (14) comportant deux branches (15 et 16) reliées entre elles par un dos (17), lequel est fixé sur une plaque latérale (20) de manière que les deux branches (15 et 16) se dirigent, transversalement au sens de déplacement (29) des plaques d'impression, en direction de l'intérieur de l'appareil de développement, et en ce que l'extrémité supérieure de la barre porteuse (3, 22) comporte, de part et d'autre, des éléments d'appui (9 à 12) par l'intermédiaire desquels la barre porteuse (3, 22), y compris la barre de guidage (2, 21) qui lui est rattachée, ainsi que le râcloir (caoutchouc râcleur 6, 24) s'appuient contre un élément profilé en U.

2. Dispositif de râclage selon la revendication 1, caractérisé en ce que la position des éléments d'appui (9 à 12) est réglable sur la barre porteuse (3, 22), dans le but de réaliser ainsi une meilleure répartition du poids cumulé de la barre porteuse (3, 22), de la barre de guidage (2, 21) et du râcloir (caoutchouc râcleur 6, 24), ce poids agissant, d'une part sur la ligne de contact entre de râcloir et la plaque d'impression, et, d'autre part, sur les deux profilés en U.

3. Dispositif de râclage selon la revendication 2, caractérisé en ce que l'élément d'appui réglable (9 à 12), situé de part et d'autre de la barre porteuse (3, 22), comporte un premier écrou moleté (10) qui est vissé sur un boulon fileté (9) enchâssé sur l'extrémité de la barre porteuse (3, 22), et qui peut être bloqué par un deuxième écrou moleté (12), vissé sur le même boulon fileté (9).

4. Dispositif de râclage selon l'une quelconque des revendications 1 à 3, caractérisé en ce que la barre de guidage (2, 21) et la barre porteuse (3, 22) forment une seule pièce compacte.

5. Dispositif de râclage selon l'une quelconque des revendications 1 à 4, caractérisé en ce que la barre de guidage (21) présente la forme d'un U inversé, indéformable, dans lequel est introduit latéralement la caoutchouc râcleur (24), ce dernier comportant une barre frontale (25), de section approximativement rectangulaire, dotée de deux griffes (28) dirigées dans le sens longitudinal et obtenues par évidement des parois latérales parallèles.

6. Dispositif de râclage selon l'une quelconque des revendications 1 à 4, caractérisé en ce que la barre de guidage (2) présente la forme approximative d'un caisson indéformable (4) qui, sur sa paroi inférieure, comporte une fente ménagée dans le sens longitudinal (5), et en ce que la caoutchouc râcleur (6) comporte une barre frontale (7) de section approximativement circulaire, qui, sur sa partie inférieure, se termine selon un bloc allongé (8) se dirigeant vers l'extérieur, en passant par cette fente longitudinale ménagée sur la paroi inférieure du profilé en U.

7. Dispositif de râclage selon l'une quelconque des revendications 1 à 6, caractérisé en ce que la caoutchouc râcleur est un caoutchouc extrudé aux silicones.

Fig. 2

Fig. 1

Fig. 3

Fig. 4